# EUROPEAN PATENT APPLICATION

(11) **EP 4 661 058 A1**
(43) Date of publication of application: **10.12.2025**
(21) Application number: 24750269.3
(22) Date of filing: 30.01.2024
(51) Int. Cl.: H01L 21/304, C11D 7/32, C11D 7/50, H01L 21/02

(54) **CLEANING AGENT COMPOSITION AND CLEANING METHOD**

(30) Priority: 01.02.2023 JP 2023013798
(71) Applicant: SHIN-ETSU CHEMICAL CO., LTD., Tokyo 1000005 (JP)
(72) Inventor: KASABATA, Koki, Annaka-shi, Gunma 379-0224 (JP); SUGO, Michihiro, Annaka-shi, Gunma 379-0224 (JP); YAMAKI, Masahiro, Annaka-shi, Gunma 379-0224 (JP)
(74) Representative: Mewburn Ellis LLP
(86) International application number: PCT/JP2024/002795
(87) International publication number: WO 2024/162320

(57) **Abstract**

The present invention pertains to a cleaning agent composition for removing a temporary adhesive for a semiconductor. The cleaning agent composition includes a quaternary ammonium salt and an organic solvent, and the organic solvent includes a heterocyclic compound containing two or more types of heteroatoms in the same ring.

## Description

### TECHNICAL FIELD

This invention relates to a detergent composition and a cleansing method using the same.

### BACKGROUND ART

The 3-dimensional semiconductor package technology is essential to achieve a higher density and larger capacity. The 3D semiconductor package technology is capable of producing a semiconductor by thinning semiconductor chips, and stacking them into a multilayer structure while forming through-silicon via (TSV) connections. To implement the technology, after a substrate having a semiconductor circuit formed thereon is furnished, the steps of grinding the non-circuit-bearing surface (referred to as "back surface", hereinafter) of the substrate for thinning, and further forming a TSV-containing electrode on the back surface are necessary. In the step of grinding the back surface of a silicon substrate, traditionally a back surface protecting tape is attached to the surface opposite to the surface to be ground to prevent wafer breakage during the grinding step. Since the protecting tape which is based on an organic resin film is flexible, but lacks strength and heat resistance, it is not compatible with the TSV forming step and the step of forming a wiring layer on the back surface.

Thus proposed is a system which is constructed by bonding a semiconductor substrate to a support of silicon or glass via an adhesive layer such that it may fully withstand the steps of back-grinding and forming TSVs and back side electrodes. The adhesive layer which bonds the substrate to the support is important in this system. The adhesive layer must bond the substrate to the support without leaving gaps and be durable enough to withstand the subsequent steps. Further the adhesive layer must allow a thin wafer to be readily separated from the support in the final stage. It is noted that the adhesive layer is herein referred to as "temporary adhesive layer" because it is finally peeled off.

After the support is peeled, sometimes parts of the temporary adhesive layer are left on the circuit-bearing surface (referred to as "front surface," hereinafter) of the semiconductor circuit-bearing substrate. Most often, the remaining temporary adhesive layer is removed with a liquid detergent. Patent Document 1 describes such a liquid detergent, that is, detergent composition for use in the cleansing of substrate surfaces. This detergent composition contains (A) 0.1 to 2.0% by weight of a quaternary ammonium salt, (B) 0.1 to 4.0% by weight of water, and (C) 94.0 to 99.8% by weight of an organic solvent.

### PRIOR ART DOCUMENTS

### PATENT DOCUMENTS

Patent Document 1: JP-A 2015-007217

### SUMMARY OF INVENTION

### TECHNICAL PROBLEM

The liquid detergent described in Patent Document 1, however, leaves room for improvement in the force of removing the temporary adhesive layer remaining on the substrate front surface.

An object of the invention, which has been made under the above-mentioned circumstances, is to provide a detergent composition which is improved in the force of removing the temporary adhesive layer remaining on the substrate front surface.

### SOLUTION TO PROBLEM

Making extensive investigations to attain the above object, the inventors have found that a detergent composition comprising a quaternary ammonium salt and an organic solvent, the organic solvent containing a heterocyclic compound having two or more types of heteroatoms in a common ring is improved in the force of removing the temporary adhesive layer remaining on the substrate front surface. The invention is predicated on this finding.

The invention provides a detergent composition and a cleansing method, as defined below.
1. A detergent composition for removing a temporary adhesive for semiconductor, comprising a quaternary ammonium salt and an organic solvent, the organic solvent containing a heterocyclic compound having two or more types of heteroatoms in a common ring.
2. The detergent composition of 1 wherein the heteroatoms are oxygen and nitrogen.
3. The detergent composition of 2 wherein the organic solvent contains a morpholine ring-bearing compound.
4. The detergent composition of 3 wherein the organic solvent contains at least one compound selected from morpholine, 4-methylmorpholine, 4-ethylmorpholine, 4-propylmorpholine, 4-acetylmorpholine, 4-(2-hydroxyethyl)morpholine, 4-acrylmorpholine, 4-(3-aminopropyl)morpholine, 1- morpholinocyclohexene, and bis(2-morpholinoethyl) ether.
5. The detergent composition of any one of 1 to 4 wherein the quaternary ammonium salt has an anion which contains at least one of fluoride, chloride, bromide, iodide, and hydroxide ions.
6. The detergent composition of any one of 1 to 5 wherein the quaternary ammonium salt has a cation which contains at least one cation selected from tetramethylammonium, tetraethylammonium, tetrapropylammonium, tetrabutylammonium, phenyltrimethylammonium, benzyltrimethylammonium, (2-hydroxyethyl)trimethylammonium, and hexadecyltrimethylammonium cations.
7. The detergent composition of any one of 1 to 6 wherein the quaternary ammonium salt contains at least one selected from tetramethylammonium fluoride, tetraethylammonium fluoride, tetrapropylammonium fluoride, and tetrabutylammonium fluoride.
8. The detergent composition of any one of 1 to 7 wherein the quaternary ammonium salt is present in an amount of 1 to 15% by weight based on the total (100% by weight) of the quaternary ammonium salt and the organic solvent.
9. In conjunction with a substrate laminate comprising a support, a temporary adhesive layer formed on the support, and a substrate having a circuit-bearing surface disposed such that the circuit-bearing surface faces the temporary adhesive layer,
   a substrate cleansing method comprising the step of removing the temporary adhesive layer left on the substrate after separation of the support, with the detergent composition of any one of 1 to 8.
10. A support or substrate cleansing method wherein a temporary adhesive layer is formed on a support or substrate,
   the method comprising the step of removing some parts of the temporary adhesive layer with the detergent composition of any one of 1 to 8.

### ADVANTAGEOUS EFFECTS OF INVENTION

The detergent composition of the invention is improved in the force of removing the temporary adhesive layer remaining on the substrate front surface.

### DESCRIPTION OF EMBODIMENTS

### [Detergent composition]

One embodiment of the invention is a detergent composition comprising a quaternary ammonium salt and an organic solvent, the organic solvent containing a heterocyclic compound having two or more types of heteroatoms in a common ring.

When the step of grinding the back surface of a substrate having a semiconductor circuit formed thereon is carried out, the substrate and the support are bonded via a temporary adhesive layer containing a temporary adhesive for substrates. As the temporary adhesive for substrates, a silicone based adhesive agent is used, for example. When the support is separated at the end of the back-grinding step, parts of the temporary adhesive of which the temporary adhesive layer is formed are sometimes left on the substrate front surface. The inventive detergent composition is advantageously used in removing such temporary adhesive remaining on the substrate front surface. When the substrate is cleansed using the inventive detergent composition, the remaining temporary adhesive (i.e., silicone based adhesive) is fully removed. This is because the inventive detergent composition uses a quaternary ammonium salt in combination with an organic solvent containing a heterocyclic compound having two or more types of heteroatoms in a common ring. It is noted that the inventive detergent composition is effective for cleansing not only the temporary adhesive remaining on the substrate which has been thinned by the back-grinding step, but also the temporary adhesive agent remaining on any substrate front surface.

### [Quaternary ammonium salt]

The quaternary ammonium salt has an anion which is preferably a fluoride, chloride, bromide, iodide or hydroxide ion. Inter alia, fluoride or hydroxide ion is preferred, the fluoride ion being most preferred.

Also, the quaternary ammonium salt preferably has a cation represented by the formula (A).

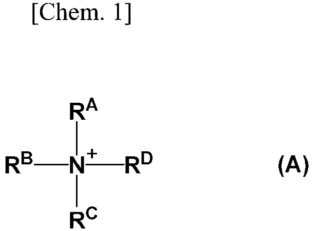

In formula (A), R^{A} to R^{D} are each independently a C₁-C₂₀ alkyl group, C₆-C₂₀ aryl group or C₇-C₂₀ aralkyl group. The alkyl group may be substituted with a hydroxy group. At least two of R^{A} to R^{D} may bond together to form a ring with the nitrogen atom to which they are attached.

Examples of the alkyl group include methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl. Examples of the aryl group include phenyl, methylphenyl, ethylphenyl, n-propylphenyl, isopropylphenyl, n-butylphenyl, isobutylphenyl, sec-butylphenyl, tert-butylphenyl, naphthyl, methylnaphthyl, ethylnaphthyl, n-propylnaphthyl, isopropylnaphthyl, n-butylnaphthyl, isobutylnaphthyl, sec-butylnaphthyl, and tert-butylnaphthyl. Examples of the aralkyl group include benzyl, 1-phenylethyl and 2-phenylethyl.

Of the cations, preferred are tetramethylammonium, tetraethylammonium, tetrapropylammonium, tetrabutylammonium, phenyltrimethylammonium, benzyltrimethylammonium, (2-hydroxyethyl)trimethylammonium, and hexadecyltrimethylammonium cations.

Of the quaternary ammonium salts, preferred are tetramethylammonium fluoride, tetraethylammonium fluoride, tetrapropylammonium fluoride, and tetrabutylammonium fluoride.

### [Organic solvent]

The organic solvent contains a heterocyclic compound having two or more types of heteroatoms in a common ring. The heteroatoms are, for example, oxygen and nitrogen atoms. Preferably -CH₂- is bonded to the opposite sides of oxygen atom. The nitrogen atom is preferably free of protons thereon, that is, tertiary nitrogen. The heterocyclic compound which contains heteroatoms is compatible with silicone based adhesives and thus perfect for removing silicone based adhesives.

The heteroatoms are not limited to oxygen and nitrogen atoms. Another heteroatom is, for example, sulfur atom. Suitable combinations of heteroatoms include combinations of oxygen and nitrogen atoms, oxygen and sulfur atoms, and nitrogen and sulfur atoms. Any of these combinations may be used as the organic solvent for dissolving the quaternary ammonium salt.

The heterocyclic compound containing oxygen and nitrogen atoms in a common ring is preferably selected from compounds having a morpholine ring, for example, morpholine, 4-methylmorpholine, 4-ethylmorpholine, 4-propylmorpholine, 4-acetylmorpholine, 4-(2-hydroxyethyl)morpholine, 4-acrylmorpholine, 4-(3-aminopropyl)morpholine, 1- morpholinocyclohexene, and bis(2-morpholinoethyl) ether.

Typical of the heterocyclic compound containing oxygen and sulfur atoms in a common ring is 1,4-thioxane.

Examples of the heterocyclic compound containing nitrogen and sulfur atoms in a common ring include thiomorpholine, thiazolidine, 2,2-dimethylthiazolidine, thiazole, 2-methylthiazole, 4-methylthiazole, 5-methylthiazole, 2,4-dimethylthiazole, 4,5-dimethylthiazole, 2,4,5-trimethylthiazole, 4-methyl-5-vinylthiazole, 2-(methylthio)thiazole, 2-methylbenzothiazole, 2,6-dimethylbenzothiazole, 2-ethylthiazole, 2-ethyl-4-methylthiazole, 2-ethyl-4,5-dimethylthiazole, 2-propylthiazole, 2-propionylthiazole, 2-isopropyl-4-methylthiazole, 2-isobutylthiazole, 2-isobutyl-4-methylthiazole, benzothiazole, 2-formylthiazole, 5-formylthiazole, 2-acetylthiazole, 5-acetyl-2,4-dimethylthiazole, 5-thiazolemethanol, 2-methoxythiazole, 2-ethoxythiazole, 2-chlorothiazole, 2-bromothiazole, 2-bromo-5-methylthiazole, 2-trimethylsilylthiazole, 5-trimethylsilylthiazole, 2-(tert-butyldimethylsilyl)thiazole, 1-(2-thiazole)piperazine, 5-(2-hydroxyethyl)-4-methylthiazole, 2-(4-methyl-5-thiazolyl)ethyl acetate, 2-(4-methyl-5-thiazolyl)ethyl butyrate, and ethyl 2-(2-benzothiazolyl)acetate.

In the detergent composition, the quaternary ammonium salt is preferably present in an amount of 1 to 15% by weight, more preferably 3 to 15% by weight based on the total (100% by weight) of the quaternary ammonium salt and the organic solvent. The detergent composition containing the quaternary ammonium salt in the range is effective for fully removing the adhesive, specifically silicone based adhesive.

The detergent composition may contain water. In this case, the content of water is preferably more than 0% to 5% by weight, more preferably more than 0% to 3% by weight, most preferably more than 0% to 1% by weight, based on the total (100% by weight) of the quaternary ammonium salt, the organic solvent, and water.

The detergent composition may contain other components, for example, surfactants, chelate agents, antioxidants, rust preventives, defoamers, pH modifiers, and aromatic compounds. The surfactants may be nonionic, anionic or cationic, with polyether-based nonionic surfactants being preferred. The other components may be used alone or in admixture. The amount of each component is preferably 0.01 to 10 parts by weight based on 100 parts by weight of the quaternary ammonium salt and the organic solvent combined.

The method of preparing the detergent composition is not particularly limited. One exemplary method is by mixing the foregoing components at the same time or in an arbitrary order.

The detergent composition should preferably have a flash point of at least 21°C, more preferably at least 30°C, even more preferably at least 50°C, most preferably at least 100°C. As long as the flash point is in the range, cleansing with the detergent composition can be performed in safety. The flash point is determined by the method of JIS K 2265-2.

### [Substrate cleansing method]

In conjunction with a substrate laminate comprising a support, a temporary adhesive layer formed on the support, and a substrate having a circuit-bearing surface disposed such that the circuit-bearing surface faces the temporary adhesive layer, another embodiment of the invention is a substrate cleansing method comprising the step of removing the temporary adhesive layer left on the substrate after separation of the support, with the detergent composition defined herein. Using the detergent composition, the temporary adhesive layer remaining on the substrate (that is, some silicone based adhesive remaining on the substrate among the silicone based adhesive of which the temporary adhesive layer is composed) can be fully removed.

The substrate cleansing method is used, for example, in the step of cleansing substrates in the fabrication of thin wafers. For example, a thin wafer is prepared by a method involving the steps of (a) furnishing a substrate laminate, (b) grinding or polishing the back surface of the substrate in the substrate laminate, (c) processing the back surface of the substrate, (d) separating the support from the substrate laminate, and (e) cleansing the front surface of the substrate with the detergent composition.

### [Step (a)]

Step (a) is to furnish a substrate laminate. The substrate laminate includes a support, a temporary adhesive layer formed on the support, and a substrate having a circuit-bearing surface disposed thereon such that the circuit-bearing surface faces the temporary adhesive layer.

Provided that the substrate has a circuit-bearing surface as the front surface and a non-circuit-bearing surface as the back surface, step (a) is to bond the circuit-bearing surface of the substrate to the support via a temporary adhesive layer (or cured layer (A)). The cured layer (A) is preferably obtained by heat curing an uncured composition comprising a thermosetting organopolysiloxane or thermoplastic organopolysiloxane as the silicone based adhesive. More specifically, step (a) includes the steps of (a-1) disposing a layer of an uncured composition comprising a thermosetting organopolysiloxane or thermoplastic organopolysiloxane as the silicone based adhesive on a substrate, (a-2) attaching a substrate having a circuit-bearing surface as the front surface and a non-circuit-bearing surface as the back surface to a support via the uncured composition layer such that the circuit-bearing surface of the substrate faces the uncured composition layer, and (a-3) heat curing the uncured composition layer into a cured layer (A). Alternatively, step (a) includes the steps of (a-1') disposing the uncured composition layer on the circuit-bearing surface of the substrate having a circuit-bearing surface as the front surface and a non-circuit-bearing surface as the back surface, (a-2) attaching the substrate to a support via the uncured composition layer, and (a-3) heat curing the uncured composition layer into a cured layer (A).

In step (a-1) or (a-1'), when the uncured composition layer is disposed, an uncured composition film may be used. Alternatively, a solution of uncured composition may be applied by such a technique as spin coating, slit coating or spray coating. Preferably the layer is disposed by spin coating. In this case, after spin coating, the uncured composition is prebaked at a temperature of preferably 80 to 250°C, more preferably 100 to 230°C, depending on the conditions under which the solvent is volatilized from the uncured composition.

In step (a-1) or (a-1'), the uncured composition layer is preferably formed such that the layer may have a thickness of 10 to 150 µm. As long as the thickness is at least 10 µm, the substrate and the support can be bonded without gaps or tightly enough to withstand the subsequent grinding step. A thickness of up to 150 µm is enough to restrain resin deformation in the subsequent heat treatment steps such as TSV forming step and ensures practical application.

In step (a-2) or (a-2'), the substrate is bonded to the support by a method, for example, by uniformly pressing the substrate at a temperature of preferably 40 to 250°C, more preferably 60 to 200°C under a reduced pressure. In the bonding step, any of commercially available wafer bonding systems may be used, for example, EVG^{®}520 IS or EVG^{®}850TB of EV Group, XBC^{®}300 of SUSS, and Synapse^{®} V by Tokyo Electron Ltd.

In step (a-3), the uncured composition layer is cured, for example, by heating the uncured composition layer preferably at 120 to 250°C, more preferably 140 to 200°C, preferably for 10 minutes to 4 hours, more preferably 30 minutes to 2 hours.

The substrate used in step (a) is typically a semiconductor wafer. Suitable semiconductor wafers include silicon wafers, germanium wafers, gallium-arsenic wafers, gallium-phosphorus wafers, and gallium-arsenic-aluminum wafers. The wafer typically has a thickness of 600 to 800 µm, more typically 625 to 775 µm, though is not critical.

The support used in step (a) is selected from silicon wafers, glass plates, and quartz wafers.

Now the cured layer (A) containing the uncured composition of thermosetting organopolysiloxane used in step (a) or a cured product thereof is described in detail.

### [Uncured composition]

The uncured composition comprises, for example, (A-1) an organopolysiloxane having at least two alkenyl groups per molecule, (A-2) an organohydrogenpolysiloxane containing at least two silicon-bonded hydrogen atoms (Si-H groups) per molecule, and (A-3) a platinum-based catalyst. Components (A-1) and (A-2) are preferably present in such amounts that the molar ratio of the total of Si-H groups in component (A-2) to the total of alkenyl groups in component (A-1) may range from 0.3/1 to 10/1. The uncured composition may further comprise (A-4) an organic solvent and/or (A-5) a reaction inhibitor.

Component (A-1) is an organopolysiloxane containing at least two alkenyl groups per molecule. Examples of component (A-1) include a linear or branched diorganopolysiloxane containing at least two alkenyl groups per molecule and an organopolysiloxane of resinous structure containing at least two alkenyl groups per molecule and containing siloxane units (Q units) represented by SiO_{4/2} units. Preferably component (A-1) has an alkenyl content of 0.6 to 9 mol%. As used herein, the alkenyl content is a proportion (mol%) of the number of alkenyl groups to the number of silicon atoms in the molecule.

Examples of the organopolysiloxane include those having the formulae (1), (2) and (3), which may be used alone or in admixture of two or more.

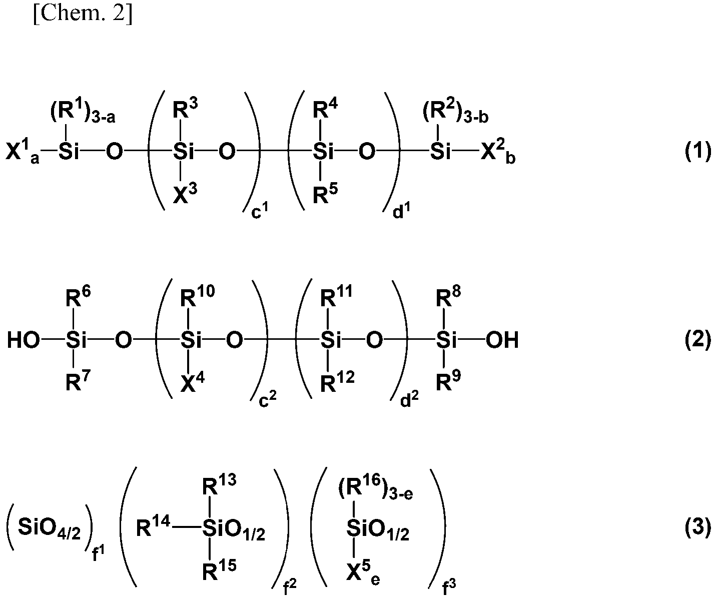

In formulae (1) to (3), R¹ to R¹⁶ are each independently a hydrocarbyl group free of aliphatic unsaturation. X¹ to X⁵ are each independently an alkenyl-containing monovalent organic group.

In formula (1), a and b are each independently an integer of 0 to 3.

In formulae (1) and (2), c¹, c², d¹ and d² are integers meeting 0 ≤ c¹ ≤ 10, 2 ≤ c² ≤ 10, 0 ≤ d¹ ≤ 100, and 0 ≤ d² ≤ 100, and a+b+c¹ ≥ 2. The subscripts a, b, c¹, c², d¹ and d² are preferably combined so as to provide an alkenyl content of 0.6 to 9 mol%.

In formula (3), e is an integer of 1 to 3, f¹, f² and f³ are such numbers that (f²+f³)/f¹ is 0.3 to 3.0 and f³/(f¹+f²+f³) is 0.01 to 0.6.

The hydrocarbyl group free of aliphatic unsaturation is preferably of 1 to 10 carbon atoms. Examples thereof include C₁-C₁₀ alkyl groups such as methyl, ethyl, propyl and butyl; C₄-C₁₀ cycloalkyl groups such as cyclohexyl; and C₆-C₁₀ aryl groups such as phenyl and tolyl. Inter alia, methyl or phenyl is preferred.

The alkenyl-containing monovalent organic group is preferably of 2 to 10 carbon atoms. Examples thereof include C₂-C₁₀ alkenyl groups such as vinyl, allyl, hexenyl and octenyl; C₃-C₁₀ (meth)acryloylalkyl groups such as acryloylpropyl, acryloylmethyl and methacryloylpropyl; C₃-C₁₀ (meth)acryloxyalkyl groups such as acryloxypropyl, acryloxymethyl, methacryloxypropyl and methacryloxymethyl; cyclohexenylethyl and vinyloxypropyl. Inter alia, vinyl is preferred from the industrial aspect.

The compound of formula (1) wherein a and b are 1 to 3 is preferred, because the molecular chain end is blocked with an alkenyl group, suggesting that the reaction can be briefly completed by virtue of the highly reactive alkenyl group at the molecular chain end. It is preferred from the industrial and economical aspects that both a and b be equal to 1.

The compound having formula (3) is an organopolysiloxane having a resinous structure or three-dimensional network structure. It is preferred from the industrial and economical aspects that e in formula (3) be equal to 1. Also, the product of an average value of e by f³/(f¹+f²+f³) is preferably 0.02 to 1.5, more preferably 0.03 to 1.0. The organopolysiloxane having formula (3) may also be used as a solution in an organic solvent.

Component (A-2) is an organohydrogenpolysiloxane having at least two, preferably at least three silicon-bonded hydrogen atoms (Si-H groups) per molecule, serving as a crosslinker. The organohydrogenpolysiloxane may be straight, branched or cyclic. The organohydrogenpolysiloxane may be used alone or in admixture of two or more.

Component (A-2) has a viscosity at 25°C of preferably 1 to 5,000 mPa·s, more preferably 5 to 500 mPa·s. As used herein, the viscosity is measured at 25°C by a rotational viscometer.

Component (A-2) is preferably blended in such amounts that the molar ratio of the total of Si-H groups in component (A-2) to the total of alkenyl groups in component (A-1), that is, (Si-H groups)/(alkenyl groups) may range from 0.3 to 10, more preferably from 1.0 to 8.0. As long as the molar ratio is 0.3 or more, an excessive reduction of crosslinking density is avoided and an uncured composition layer can be fully cured. As long as the molar ratio is 10 or less, an excessive increase of crosslinking density is avoided and a satisfactory bonding force and tack are available. As long as the molar ratio is 10 or less, the uncured composition has a long pot life.

The alkenyl-containing diorganopolysiloxane as component (A-1) and the organohydrogenpolysiloxane as component (A-2) is preferably oily or gum-like.

Component (A-3) is a platinum based catalyst, i.e., platinum group metal catalyst. Examples of the platinum based catalyst include chloroplatinic acid, alcohol solutions of chloroplatinic acid, the reaction products of chloroplatinic acid with alcohols, the reaction products of chloroplatinic acid with olefin compounds, and the reaction products of chloroplatinic acid with vinyl-containing siloxanes. The platinum based catalyst may be used alone or in admixture.

Component (A-3) is preferably blended in such amounts as to give 1 to 5,000 ppm, more preferably 5 to 2,000 ppm by weight of platinum group metal based on the total of components (A-1) and (A-2). As long as the platinum group metal is 1 ppm or more, an uncured composition layer is unlikely to lose curability so that a lowering of crosslinking density and a lowering of retaining force are avoided. As long as the platinum group metal is 5,000 ppm or less, the uncured composition has a long pot life.

Component (A-4) is an organic solvent. The organic solvent is not particularly limited as long as the components of the uncured composition are dissolvable. Examples of the organic solvent include hydrocarbon solvents such as pentane, hexane, cyclohexane, isooctane, nonane, decane, p-menthane, pinene, isododecane, and limonene, and silicone based solvents.

When the uncured composition contains the organic solvent, the amount of the solvent is preferably 10 to 900 parts by weight, more preferably 25 to 400 parts by weight, even more preferably 40 to 300 parts by weight per 100 parts by weight of components (A-1) and (A-2) combined. The organic solvent may be used alone or in admixture.

Component (A-5) is a reaction inhibitor. When an uncured composition is prepared or coated onto a substrate, the reaction inhibitor is added, if necessary, for preventing the uncured composition from a viscosity buildup or gelation prior to heat cure.

Examples of the reaction inhibitor include 3-methyl-1-butyn-3-ol, 3-methyl-1-pentyn-3-ol, 3,5-dimethyl-1-hexyn-3-ol, 1-ethynylcyclohexanol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Inter alia, 1-ethynylcyclohexanol and 3-methyl-1-butyn-3-ol are preferred.

When the uncured composition contains the reaction inhibitor, its amount is preferably 0.01 to 8.0 parts by weight, more preferably 0.05 to 2.0 parts by weight per 100 parts by weight of components (A-1) and (A-2) combined. As long as the amount is 0.01 part by weight or more, the reaction inhibiting effect is fully exerted. As long as the amount is 8.0 parts by weight or less, the uncured composition layer is unlikely to lose curability. The reaction inhibitor may be used alone or in admixture.

The uncured composition may contain other components. Suitable other components include fillers such as silica; non-reactive polyorganosiloxanes such as polydimethylsiloxane and polydimethyldiphenylsiloxane; antioxidants such as phenol, quinone, amine, phosphorus, phosphite, sulfur, and thioether compounds; photostabilizers such as triazoles and benzophenones; flame retardants such as phosphate esters, halogen, phosphorus, and antimony compounds; and antistatic agents such as cationic, anionic and nonionic surfactants. The other components may be used alone or in admixture.

When the uncured composition contains other components, the other components are blended as long as the objects of the invention are not interfered. When the filler is used to enhance heat resistance, for example, its amount is preferably up to 50 parts by weight per 100 parts by weight of components (A-1) and (A-2) combined.

### [Temporary adhesive layer (Cured layer (A))]

The cured layer (A) is obtained by heat curing the uncured composition layer as mentioned previously.

The cured layer (A) disposed on the support preferably has a peeling force of 10 to 500 mN/25 mm, more preferably 30 to 500 mN/25 mm, even more preferably 50 to 200 mN/25 mm when the cured layer is peeled (interfacial peeling) from the support. As used herein, the peeling force is measured by a 180° peeling test of pulling a specimen of 25 mm wide at a rate of 5 mm/sec to peel it from the support. As long as the peeling force is 10 mN/25 mm or more, peeling in the working step (to be described later) is restrained. As long as the peeling force is 500 mN/25 mm or less, the cured layer (A) can be readily peeled from the support.

The cured layer (A) disposed on the substrate preferably has a peeling force of 50 to 1,000 mN/25 mm, more preferably 70 to 1,000 mN/25 mm, even more preferably 80 to 500 mN/25 mm when the cured layer is peeled (interfacial peeling) from the substrate. As used herein, the peeling force is measured by a 180° peeling test of pulling a specimen of 25 mm wide at a rate of 5 mm/sec to peel it from the substrate. As long as the peeling force is 50 mN/25 mm or more, peeling in the working step (to be described later) is restrained and peeling is unlikely to occur throughout the high-temperature process. As long as the peeling force is 1,000 mN/25 mm or less, the cured layer (A) can be peeled from the substrate using a tape.

Also, the cured layer (A) preferably has a storage elastic modulus at 25°C of 1×10⁶ to 1×10⁹ Pa. As long as the storage elastic modulus is in the range, the cured layer fully withstands the grinding step (to be described later) and is effective for reducing the warpage of the substrate. Then there occur few problems like a failure of loading on an equipment in the subsequent step.

### [Step (b)]

Step (b) is grinding or polishing the back surface of the substrate in the substrate laminate. In step (b), the thickness of the substrate is reduced by grinding or polishing the back surface (i.e., non-circuit-bearing surface) of the substrate bonded to the support. The thinned substrate typically has a thickness of 5 to 300 µm, preferably 10 to 100 µm. The grinding technique is not particularly limited and any well-known technique may be used. Preferably grinding is carried out while spraying water to the substrate and the grinding wheel (of diamond) for cooling. The tool for grinding the back surface of the substrate is, for example, DAG-810 (trade name, DISCO Corp.). Also, the back surface of the substrate may be subjected to chemical mechanical polishing (CMP).

### [Step (c)]

Step (c) is to work the back surface of the substrate. In step (c), the back surface (i.e., non-circuit-bearing surface) of the substrate which has been thinned by back griding or polishing in step (b). This step includes a variety of processes used on the wafer level. Suitable processes encompass electrode formation, metal connector formation, and protective film formation. More specifically, prior art well-known processes are included, for example, metal sputtering for forming electrodes or the like, wet etching of etching a sputtered metal layer, pattern formation by coating, exposure and development of resist to form a mask for metal connector formation, resist removal, dry etching, metal plating formation, silicon etching for TSV formation, and oxide film formation on silicon surface. Further, cutting of the thinned wafer into chips by dicing is also included.

### [Step (d)]

Step (d) is to separate the support from the substrate laminate. In step (d), the support is separated from the substrate laminate which has been worked in step (c). The separation step is typically carried out at a relatively low temperature of room temperature to about 60°C. With either one of the substrate and the support of the substrate laminate being horizontally secured, the other is lifted at a certain angle relative to the horizontal direction. Alternatively, a protective film is attached to the ground surface of the substrate before the substrate is separated together with the protective film by a peeling process.

The peeling process includes the step (d-1) of bonding a dicing tape to the ground surface of the substrate, the step (d-2) of vacuum sucking the dicing tape surface to the suction surface, and the step (d-3) of separating the support from the substrate in a peel-off way while the suction surface is kept at a temperature of 10°C to 100°C. In this case, the support may be readily separated from the substrate and the subsequent dicing step may be readily carried out.

At the end of the separation step as mentioned above, in one case wherein the cured layer (A) is separated together with the support, only the substrate is obtained. In another case wherein only the support is separated from the substrate laminate, the substrate having the cured layer (A) disposed thereon is obtained. In the latter case, by further separating the cured layer (A) from the substrate in a tape peeling way, only the substrate is obtained. The preferred tape used for peeling is a tape using silicone pressure-sensitive adhesive. For example, polyester film adhesive tape No. 646S and No. 648 (Teraoka Seisakusho Co., Ltd.) are advantageously used.

### [Step (e)]

Step (e) is to cleanse the surface of the substrate with the detergent composition. In step (e), the surface (circuit-bearing surface) of the substrate is cleansed with the detergent composition to remove the cured layer (A) or the cured product of the uncured composition remaining thereon. Then, even after the support and the cured layer (A) are separated in step (d), some of the cured layer (A) remaining on the substrate surface can be fully removed. The substrate (thin wafer) thus obtained may be advantageously used in the subsequent 3D semiconductor packaging process.

The cleansing step may be carried out by immersing the substrate in the detergent composition. The immersing time is preferably from 10 seconds to 30 minutes, more preferably from 30 seconds to 10 minutes. The cleansing step may also be carried out by spraying the detergent composition to the substrate. Further, puddle cleansing with the detergent composition may be carried out as well as shaking and ultrasonic cleansing. The temperature at which cleansing is carried out is preferably 10 to 50°C, more preferably 20 to 40°C.

It is noted that the substrate as cleansed may be washed with water or rinsed with alcohol and dried.

In step (a), an uncured composition layer of thermosetting organopolysiloxane is cured to form a cured layer (A) as a temporary adhesive layer. The temporary adhesive layer is not limited to the cured layer (A), and a temporary adhesive layer obtained from another silicone-based adhesive may also be used. The cured layer (A) is a single layer whereas at least one other temporary adhesive layer may be formed on the cured layer (A). The other temporary adhesive layer on the cured layer (A) is selected from silicone, acrylic, phenolic, epoxy and polyimide based adhesives though not critical. An organopolysiloxane-containing layer having a function other than the temporary adhesive layer may be formed between the support and the substrate. Examples of the other silicone-based adhesive include those described in WO 2015/115060, JP-A 2012-144616, and JP-A 2014-131004. In any case, the temporary adhesive layer remaining on the substrate surface can be fully removed as long as the detergent composition is used.

In step (d), the support may be separated as mentioned above. The separation of the support may be any of light-assisted peeling, heat peeling, solvent peeling, and mechanical peeling. In any case, the temporary adhesive layer remaining on the substrate surface or support surface can be fully removed as long as the detergent composition is used.

In the case of light-assisted peeling, a separable layer is typically formed in the substrate laminate in step (a). That is, a separable layer is formed between the support and the temporary adhesive layer. The separable layer, which is not particularly limited, is formed of a well-known material which is altered upon absorption of light transmitted by the support, preferably carbon or an aromatic hydrocarbon compound. As used herein, alteration indicates the state that the separable layer is broken by a weak external force or the state that the bonding force between the separable layer and the adjoining layer is reduced. Next, the substrate laminate having the separable layer is subjected to steps (b) and (c) as mentioned above. In the subsequent step (d), the support is separated from the substrate laminate by light-assisted peeling. At this point, the emission from a well-known laser is directed to the substrate laminate through the support. A suitable laser capable of emitting light of wavelength capable of altering the material of which the separable layer is made, for example, light of wavelength 300 to 400 nm may be selected. Then the separable layer is altered, allowing the support to be separated. In the subsequent step (e), the surface of the substrate resulting from light-assisted peeling is cleansed with the detergent composition.

In the case of heat peeling, a temporary adhesive layer is typically formed in step (a) using a silicone based adhesive adapted to lose its bonding force upon heating, preferably at 350 to 400°C. Next, the substrate laminate having the temporary adhesive layer is subjected to steps (b) and (c) as mentioned above. In the subsequent step (d), the support is separated from the substrate laminate by heat peeling. In the subsequent step (e), the surface of the substrate resulting from heat peeling is cleansed with the detergent composition.

In the case of solvent peeling, the support is separated from the substrate laminate by solvent peeling in step (d). At this point, a suitable solvent capable of dissolving the silicone based adhesive of which the temporary adhesive layer is made may be selected. Suitable solvents include hydrocarbons of 4 to 20 carbon atoms, aromatic and ether solvents. In the subsequent step (e), the surface of the substrate resulting from solvent peeling is cleansed with the detergent composition.

It is noted that the temporary adhesive remaining after peeling step (d) has a thickness prior to cleansing from more than 0 µm to the thickness of the temporary adhesive layer prior to peeling, preferably from more than 0 µm to the thickness of the temporary adhesive layer in the case of light-assisted peeling or heat peeling, and from more than 0 µm to 100 µm, more preferably from more than 0 µm to 60 µm in the case of mechanical peeling or solvent peeling.

It is also noted that in step (a), the entirety of the circuit-bearing surface of the substrate is bonded to the support through the temporary adhesive layer obtained from one uncured composition. For adjusting the bonding force between the support and the substrate, it is acceptable to form a first temporary adhesive layer on a portion of the substrate surface and to form a second temporary adhesive layer on the remainder of the substrate surface. That is, the entirety of the substrate surface may be covered with the first and second temporary adhesive layers. The first and second temporary adhesive layers are independently formed of a suitable silicone-based adhesive chosen to obtain a desired bonding force.

Each of the first and second temporary adhesive layers is preferably a heat cured product of an uncured composition as mentioned above. The uncured compositions, prior to heat cure, for the first and second temporary adhesive layers may be different or identical as long as they fall in the above-defined range of the uncured composition. The first and second temporary adhesive layers deposited on the substrate surface after substrate separation may be cleanly removed using the detergent composition.

Further, in this case, the detergent composition is advantageously used when the temporary adhesive layer is formed. First, in step (a), the first temporary adhesive layer is formed on the entire surface of the substrate. Next, the unnecessary portion of the first temporary adhesive layer where the second temporary adhesive layer is to be formed is subjected to edge cut treatment with the detergent composition. Using the detergent composition, the unnecessary portion of the first temporary adhesive layer on the substrate is cleanly removed. On the edge cut portion, the second temporary adhesive layer is formed. Then, the circuit-bearing surface of the substrate is bonded to the support via the first and second temporary adhesive layers. Next, in step (b), the back surface of the substrate in the substrate laminate having the first and second temporary adhesive layers is ground or polished. Although the temporary adhesive layer is formed on the substrate in the foregoing embodiment, the temporary adhesive layer may also be formed on the support. That is, the method for cleansing the support or substrate according to the invention involves the steps of forming a temporary adhesive layer on the support or substrate, removing some of the temporary adhesive layer by puddling, shaking or ultrasonication while immersing in the detergent composition preferably at 20 to 40°C for 30 seconds to 10 minutes, or removing by spraying the detergent composition. The substrate after removal is washed with water or cleansed with a solvent and dried, if necessary, before it is used in a semiconductor processing system.

### EXAMPLES

Examples and Comparative Examples are given below for illustrating the invention although the invention is not limited thereto. In Examples and Comparative Examples, Mw is measured by gel permeation chromatography (GPC) versus monodisperse polystyrene standards using a GPC column TSKGEL Super HZM-H (Tosoh Corp.) under analysis conditions, flow rate: 0.6 mL/min, eluent: tetrahydrofuran, and column temperature: 40°C.

### [1] Preparation of liquid detergent

### [Example 1-1]

Liquid detergent 1 was prepared by adding tetrabutylammonium fluoride as a quaternary ammonium salt to 4-methylmorpholine, and stirring at room temperature. Notably, tetrabutylammonium fluoride was dissolved in liquid detergent 1. The liquid detergent was prepared so as to contain 5% by weight of tetrabutylammonium fluoride based on the total (100% by weight) of tetrabutylammonium fluoride and 4-methylmorpholine.

### [Example 1-2]

Liquid detergent 2 was prepared by the same procedure as in Example 1-1 except that the detergent contained 2% by weight of tetrabutylammonium fluoride based on the total (100% by weight) of tetrabutylammonium fluoride and 4-methylmorpholine.

### [Example 1-3]

Liquid detergent 3 was prepared by the same procedure as in Example 1-1 except that the detergent contained 12% by weight of tetrabutylammonium fluoride based on the total (100% by weight) of tetrabutylammonium fluoride and 4-methylmorpholine.

### [Example 1-4]

Liquid detergent 4 was prepared by the same procedure as in Example 1-1 except that 4-ethylmorpholine was used instead of 4-methylmorpholine.

### [Example 1-5]

Liquid detergent 5 was prepared by the same procedure as in Example 1-1 except that 4-acetylmorpholine was used instead of 4-methylmorpholine.

### [Example 1-6]

Liquid detergent 6 was prepared by the same procedure as in Example 1-1 except that tetraethylammonium fluoride was used instead of tetrabutylammonium fluoride.

### [Comparative Example 1-1]

Liquid detergent 7 was prepared by adding tetramethylammonium hydroxide as a quaternary ammonium salt and water to 1-butoxy-2-propanol, and stirring at room temperature. Notably, tetramethylammonium hydroxide was dissolved in liquid detergent 7. The liquid detergent was prepared so as to contain 95% by weight of 1-butoxy-2-propanol, 2% by weight of tetramethylammonium hydroxide, and 3% by weight of water based on the total (100% by weight) of 1-butoxy-2-propanol, tetramethylammonium hydroxide, and water.

### [Comparative Example 1-2]

Liquid detergent 8 was prepared by adding tetrabutylammonium fluoride as a quaternary ammonium salt to ethylene glycol, and stirring at room temperature. Notably, tetrabutylammonium fluoride was dissolved in liquid detergent 8. The liquid detergent was prepared so as to contain 5% by weight of tetrabutylammonium fluoride based on the total (100% by weight) of ethylene glycol and tetrabutylammonium fluoride.

### [Comparative Example 1-3]

Liquid detergent 9 was 4-methylmorpholine alone.

### [Comparative Example 1-4]

Liquid detergent 10 was isopropanol alone.

### [2] Substrate cleansing test 1

### [Example 2-1]

First, a resin solution was prepared by adding 40 parts by weight of organohydrogenpolysiloxane having the formula (M-1) shown below and 0.7 part by weight of ethynyl cyclohexanol to a solution consisting of 100 parts by weight of polydimethylsiloxane containing 2.5 mol% of vinyl group on molecular side chain and having a number average molecular weight (Mn) of 30,000 and 200 parts by weight of toluene, followed by mixing. Further, 0.2 part by weight of platinum catalyst CAT-PL-5 (Shin-Etsu Chemical Co., Ltd.) was added to the mixture, which was passed through a membrane filter of 0.2 µm. In the resin solution, the molar ratio of Si-H groups in the Si-H group-containing organohydrogenpolysiloxane to alkenyl groups in the alkenyl group-containing organopolysiloxane was 1.1. The resin solution thus prepared was coated onto a substrate by the above-mentioned technique and heat cured to form a cured layer (A). The cured layer (A) was measured for peeling force at room temperature according to JIS K 6854, finding a peeling force of 216 mN/25 mm. The cured layer (A) also had a storage elastic modulus at 25°C of 5.3x10⁶ Pa. Notably, the storage elastic modulus was measured at 25°C and frequency 1 Hz by Rheogel-E4000 (UBM Co., Ltd.).

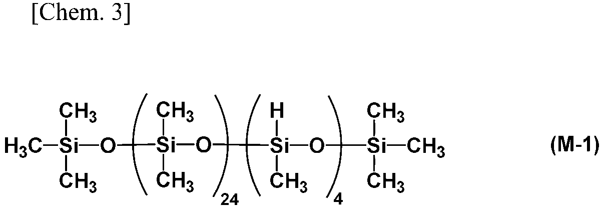

### [Step (a)]

Next, a substrate laminate was prepared. Specifically, the resin solution was spin coated onto a 200-mm glass wafer of 700 µm thick as a support and heated on a hotplate at 50°C for 3 minutes to form an uncured composition layer of 35 µm thick. Then a silicon wafer of diameter 200 mm and thickness 725 µm having copper posts of height 10 µm and diameter 40 µm formed on its entire surface as a substrate was bonded to the support such that the copper post-bearing surface faced the uncured composition layer. The bonding was performed by a wafer bonding system (EVG^{®}520 IS by EV Group) under conditions: bonding temperature 50°C, chamber interior pressure up to 10⁻³ mbar, and load 10 kN. After bonding, the bonded substrate was heated in an oven at 200°C for 2 hours to cure the uncured composition layer and then cooled to room temperature. In this way, the substrate laminate was obtained.

### [Step (b)]

Next, the back surface of the substrate of the substrate laminate was ground. Specifically, the back surface of the silicon wafer was ground by a surface grinder (DAG^{®}810 by DISCO Corp.) with a diamond wheel. Grinding was continued until the final substrate thickness reached 50 µm.

### [Step (c)]

Next, a simulative heating step was carried out as the step of working the back surface of the substrate. Specifically, the substrate laminate after back surface grinding was heated on a hotplate at 260°C for 10 minutes.

### [Step (d)]

Next, the support was separated from the substrate laminate. Specifically, using a dicing frame, a dicing tape was attached to the back surface (non-circuit-bearing surface) of the silicon wafer. The dicing tape side was set on a suction plate by vacuum suction. Thereafter, the glass wafer was separated at room temperature by lifting it at one point with a forceps. Thereafter, polyester film adhesive tape No. 648 (Teraoka Seisakusho Co., Ltd.) was attached to the thus exposed temporary adhesive layer for tape peeling or separation. In this way, the temporary adhesive layer was separated from the silicon wafer.

### [Step (e)]

Finally, the substrate was cleansed on its surface using liquid detergent 1. Specifically, the silicon wafer was immersed in liquid detergent 1 at room temperature for 5 minutes, washed with isopropanol, and dried at room temperature, obtaining the substrate for the cleansing test.

### [Examples 2-2 to 2-6 and Comparative Examples 2-1 to 2-4]

Substrates for the cleansing test were prepared by the same procedure as in Example 2-1 except that in step (e), liquid detergent 2, 3, 4, 5, 6, 7, 8, 9 or 10 was used instead of liquid detergent 1.

### [Test method]

The front surface (circuit-bearing surface) of the substrate having undergone step (d) was analyzed by XPS to determine the amount of Si on the surface, finding a Si content of 23%. The Si content was exclusive of Si originating from the silicon substrate. The surface (circuit-bearing surface) of the substrate having undergone step (e) was also analyzed by XPS to determine the amount of Si on the surface. When the Si content after cleansing was less than 5%, the liquid detergent was regarded as having an excellent force for removing the temporary adhesive layer remaining on the substrate surface. It is noted that XPS was carried out using X-ray photoelectron spectroscopy system (trade name PHI Quantera SXM, Ulvac-PHI, Inc.), specifically monochromatic Al Kα as X-ray source, power 25 W (15 kV, 100 µm diameter), photoelectron take-off angle 45°, pulse energy 55.0 eV, and step resolution 0.05 eV. The area of analysis had a diameter of 500 µm. The results are shown in Table 1.

**[Table 1]**

| | Liquid detergent | Si content after 5 min. immersion |
|---|---|---|
| Example 2-1 | 1 | 1% |
| Example 2-2 | 2 | 4% |
| Example 2-3 | 3 | 1% |
| Example 2-4 | 4 | 1% |
| Example 2-5 | 5 | 2% |
| Example 2-6 | 6 | 2% |
| Comparative Example 2-1 | 7 | 7% |
| Comparative Example 2-2 | 8 | 22% |
| Comparative Example 2-3 | 9 | 24% |
| Comparative Example 2-4 | 10 | 23% |

As shown in Table 1, when substrates were cleansed using liquid detergents 1 to 6, the amount of Si remaining after cleansing was less than 5%, indicating that liquid detergents within the scope of the invention have excellent cleansing forces. By contrast, when substrates were cleansed using liquid detergents 7 to 10, the amount of Si remaining after cleansing was more than 5%, indicating a failure to obtain a satisfactory cleansing effect. It is demonstrated that the detergent composition within the scope of the invention has an excellent force of removing the temporary adhesive layer remaining on the substrate surface.

### [3] Substrate cleansing test 2

### [Example 3-1]

A substrate for the cleansing test was prepared by the same procedure as in Example 2-1.

### [Examples 3-2 to 3-6 and Comparative Examples 3-1 to 3-4]

Substrates for the cleansing test were prepared by the same procedure as in Example 2-1 except that in step (e), liquid detergent 2, 3, 4, 5, 6, 7, 8, 9 or 10 was used instead of liquid detergent 1.

### [Test method]

The surface (peeled surface) of the substrate having undergone step (d) was measured for a contact angle with pure water, finding a contact angle of 108°. The surface (peeled surface) of the substrate having undergone step (e) was also measured for a contact angle with pure water. After a silicon wafer not having a circuit-bearing surface was subjected to only step (e), it was measured for a contact angle with pure water, finding a contact angle of 21°. When the contact angle with pure water after cleansing is 21±1°, the liquid detergent is regarded as having an excellent force of removing the temporary adhesive layer remaining on the substrate surface. It is noted that the contact angle was measured by a contact angle meter (Drop Master^{®} DMo-701, Kyowa Interface Science Co., Ltd.). The contact angle was an average value of 10 measurements using 3.0 µL of pure water. The results are shown in Table 2.

**[Table 2]**

| | Liquid detergent | Si content after 5 min. immersion |
|---|---|---|
| Example 3-1 | 1 | 21° |
| Example 3-2 | 2 | 22° |
| Example 3-3 | 3 | 22° |
| Example 3-4 | 4 | 21° |
| Example 3-5 | 5 | 21° |
| Example 3-6 | 6 | 21° |
| Comparative Example 3-1 | 7 | 67° |
| Comparative Example 3-2 | 8 | 108° |
| Comparative Example 3-3 | 9 | 109° |
| Comparative Example 3-4 | 10 | 108° |

As shown in Table 2, when substrates were cleansed using liquid detergents 1 to 6, the contact angle with pure water after cleansing was within 21±1°, indicating that liquid detergents within the scope of the invention have excellent cleansing forces. By contrast, when substrates were cleansed using liquid detergents 7 to 10, the contact angle with pure water after cleansing exceeded 21±1°, indicating a failure to obtain a satisfactory cleansing effect. It is demonstrated that the detergent composition within the scope of the invention has an excellent force of removing the temporary adhesive layer remaining on the substrate surface.

## Claims

1. A detergent composition for removing a temporary adhesive for semiconductor, comprising a quaternary ammonium salt and an organic solvent, the organic solvent containing a heterocyclic compound having two or more types of heteroatoms in a common ring.

2. The detergent composition of claim 1 wherein the heteroatoms are oxygen and nitrogen.

3. The detergent composition of claim 2 wherein the organic solvent contains a morpholine ring-bearing compound.

4. The detergent composition of claim 3 wherein the organic solvent contains at least one compound selected from morpholine, 4-methylmorpholine, 4-ethylmorpholine, 4-propylmorpholine, 4-acetylmorpholine, 4-(2-hydroxyethyl)morpholine, 4-acrylmorpholine, 4-(3-aminopropyl)morpholine, 1- morpholinocyclohexene, and bis(2-morpholinoethyl) ether.

5. The detergent composition of claim 1 wherein the quaternary ammonium salt has an anion which contains at least one of fluoride, chloride, bromide, iodide, and hydroxide ions.

6. The detergent composition of claim 1 wherein the quaternary ammonium salt has a cation which contains at least one cation selected from tetramethylammonium, tetraethylammonium, tetrapropylammonium, tetrabutylammonium, phenyltrimethylammonium, benzyltrimethylammonium, (2-hydroxyethyl)trimethylammonium, and hexadecyltrimethylammonium cations.

7. The detergent composition of claim 1 wherein the quaternary ammonium salt contains at least one selected from tetramethylammonium fluoride, tetraethylammonium fluoride, tetrapropylammonium fluoride, and tetrabutylammonium fluoride.

8. The detergent composition of claim 1 wherein the quaternary ammonium salt is present in an amount of 1 to 15% by weight based on the total (100% by weight) of the quaternary ammonium salt and the organic solvent.

9. In conjunction with a substrate laminate comprising a support, a temporary adhesive layer formed on the support, and a substrate having a circuit-bearing surface disposed such that the circuit-bearing surface faces the temporary adhesive layer,
a substrate cleansing method comprising the step of removing the temporary adhesive layer left on the substrate after separation of the support, with the detergent composition of any one of claims 1 to 8.

10. A support or substrate cleansing method wherein a temporary adhesive layer is formed on a support or substrate,
the method comprising the step of removing some parts of the temporary adhesive layer with the detergent composition of any one of claims 1 to 8.
